# FASCICULE DE BREVET EUROPEEN

(11) **EP 0 726 614 B1**
(45) Date de publication et mention de la délivrance du brevet: **06.08.1997**
(21) Numéro de dépôt: 96400113.5
(22) Date de dépôt: 17.01.1996
(51) Int. Cl.: H01R 9/24, H05K 7/14

(54) **Dispositif d'interfaçage électrique composable**
Zusammensetzbare elektrische Schnittstellenvorrichtung
Composable electrical interface device

(30) Priorité: 07.02.1995 FR 9501486
(43) Date de publication de la demande: 14.08.1996
(73) Titulaire: SCHNEIDER ELECTRIC SA, 92100 Boulogne Billancourt (FR)
(72) Inventeur: Barbier, René, F-21560 Remilly sur Tille (FR); Colonna, Jean-Marie, F-21000 Dijon (FR); Gyongyosi, Andras, F-21000 Dijon (FR); Soulas, Marc, F-21000 Dijon (FR); Vianes, André, F21121 Darois (FR)
(74) Mandataire: Carias, Alain

(56) Documents cités:
- EP-A- 0 096 961
- EP-A- 0 518 762
- EP-A- 0 612 205
- DE-A- 4 031 772
- DE-U- 9 311 526
- US-A- 4 672 511

## Description

La présente invention concerne un dispositif d'interfaçage du type comportant une carte à circuit imprimé susceptible d'être reliée à une unité de traitement, notamment une unité de traitement d'automate programmable, une embase allongée dotée de rainures longitudinales pour recevoir la carte, des éléments d'interface - constituants ou circuits - soudés à la carte et au moins un bornier également soudé à la carte pour permettre de connecter celle-ci à un équipement électrique susceptible d'être exploité ou commandé par l'unité de traitement.

Dans les dispositifs d'interfaçage connus de ce type, les constituants ou sous-ensembles d'interface, tels que relais ou embases de relais, circuits de traitement,... (organes dits actifs), diodes de visualisation, fusibles ou sectionneurs (organes dits passifs), sont soudés à la carte dans autant de configurations que d'applications souhaitées. Ces dispositifs sont donc réalisables dans de nombreuses versions adaptées aux demandes de la clientèle, mais cette diversité suppose, même si l'on conserve un format unique d'embase et de carte, la fabrication et la gestion d'un nombre important de produits. A l'inverse, si l'on veut réaliser un tel dispositif d'interfaçage à partir d'un seul boîtier monobloc, ou de quelques boîtiers monobloc, intégrant les borniers et diodes de visualisation, on se heurte nécessairement à une forte limitation de la gamme, avec comme corollaire l'impossibilité de répondre entièrement aux souhaits de la clientèle.

L'invention a pour but de concilier, dans une gamme de dispositifs d'interfaçage du type décrit, une grande diversité d'applications et une grande simplicité de fabrication et de gestion, tout en garantissant une bonne rigidité d'assemblage.

Selon l'invention,
- les éléments d'interface sont logés dans des boîtiers modulaires distincts dont les longueurs sont égales ou multiples entier d'un module, chaque boîtier comprenant un bandeau d'ouvertures de visualisation ou de manoeuvre pour des bornes, réparties avec un pas déterminé selon la longueur de l'embase,
- les boîtiers modulaires présentent sur leurs faces latérales des rainures et languettes complémentaires d'assemblage mutuel orientées perpendiculairement au plan de la carte pour former un ensemble jointif composable et rigide.

Il résulte de cette disposition une grande souplesse de composition de modules fonctionnels en même temps qu'une homogénéité de présentation et une bonne rigidité d'assemblage des boîtiers entre eux et de l'ensemble embase-carte aux boîtiers. Cette rigidité peut être accentuée par interaction du boîtier modulaire avec un bord de la carte. Les boîtiers modulaires présentent avantageusement une longueur multiple de quatre ou huit fois le pas des bornes.

Il est avantageux que les boîtiers intègrent un bandeau d'ouvertures de visualisation et des conducteurs de lumière associés, un bandeau d'ouvertures d'accès à une première rangée de bornes et, entre ces deux bandeaux, une partie centrale en retrait pour recevoir un couvercle longitudinal, de préférence pivotant, commun à l'ensemble des boîtiers.

Dans certains cas, la rigidité d'assemblage peut être renforcée par la présence de crochets de positionnement à l'arrière des boîtiers modulaires, pour s'engager dans des encoches prévues à intervalles réguliers sur un bord longitudinal de la carte et rester retenus, à l'encontre d'efforts d'extraction vers l'avant, par un rabattement longitudinal de l'embase adjacent à la rainure de l'embase qui loge le bord de la carte.

La description faite ci-après en regard des dessins fera ressortir les caractéristiques et les avantages de l'invention. Parmi ces dessins :
- La figure 1 représente en perspective un dispositif d'interfaçage conforme à l'invention.
- La figure 2 est une vue éclatée du dispositif d'interfaçage.
- Les figures 3 à 5 représentent en perspective un bloc d'alimentation, un boîtier modulaire d'interface et un bornier modulaire additionnel.
- La figure 6 est une vue de côté en coupe selon VI-VI du dispositif d'interfaçage.

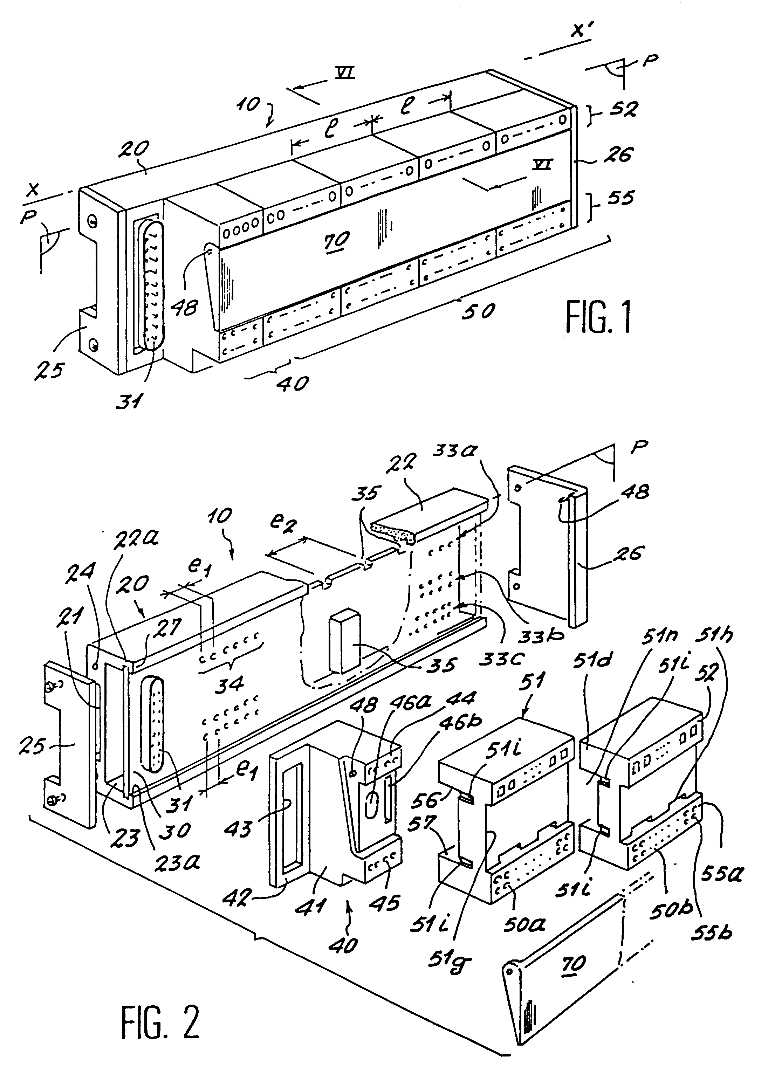

Le dispositif d'interfaçage 10 illustré sur les figures 1, 2 et 6 comprend une embase 20 allongée s'étendant selon une direction X-X', une carte à circuit imprimé 30 de plan général P logée dans l'embase selon la longueur de celle-ci, un bloc d'alimentation 40 et plusieurs blocs modulaires d'interface 50 fixés par soudure à la carte 30, ainsi qu'un couvercle général frontal 70.

L'embase 20 est une pièce profilée en U en matière plastique, de préférence obtenue par extrusion et découpée à la longueur voulue correspondant au nombre de blocs modulaires souhaités. Elle pourrait aussi être moulée et/ou être métallique. L'embase présente une âme 21 parallèle au plan P, une aile supérieure 22 et une aile inférieure 23. Les ailes 22,23 font saillie vers l'avant à partir de l'âme et comprennent des rainures en regard 22a,23a orientées selon la direction X-X' pour recevoir par glissement la carte 30. Près des raccordements des ailes à l'âme, l'embase comprend des orifices 24 qui permettent de fixer des flasques latéraux de fermeture 25,26 au moyen de vis. Les rainures 22a,23a sont bordées vers l'avant par des rabattements profilés 27. L'embase peut être fixée à sa partie arrière à un support, par exemple un profilé normalisé, par des moyens qui n'ont pas besoin d'être décrits.

La carte à circuit imprimé 30 porte à l'une de ses extrémités un connecteur multipoints 31 de liaison avec une unité de traitement, par exemple un automate programmable, et des orifices 32,33 permettant l'implantation de pattes ou de broches d'éléments de visualisation, de relayage, de traitement, de bornes, dont les uns sont alloués au bloc d'alimentation 40 (orifices 32) et les autres par groupes aux blocs d'interface 50 (orifices 33).

Les orifices 33 associés aux blocs d'interface 50 sont disposés selon plusieurs rangées et, dans ces rangées, sont répartis régulièrement avec un pas déterminé l1. Ces rangées comprennent des rangées supérieures 33a qui reçoivent les pattes de connexion de diodes électroluminescentes 34, des rangées médianes 33b qui reçoivent les pattes de connexion d'éléments passifs ou actifs, par exemple de fusibles ou sectionneurs, de relais 35 non débrochables ou de circuits de traitement, et des rangées inférieures 33c qui reçoivent les pattes de connexion de pièces conductrices de borniers modulaires intégrés ou rapportés aux blocs d'interface.

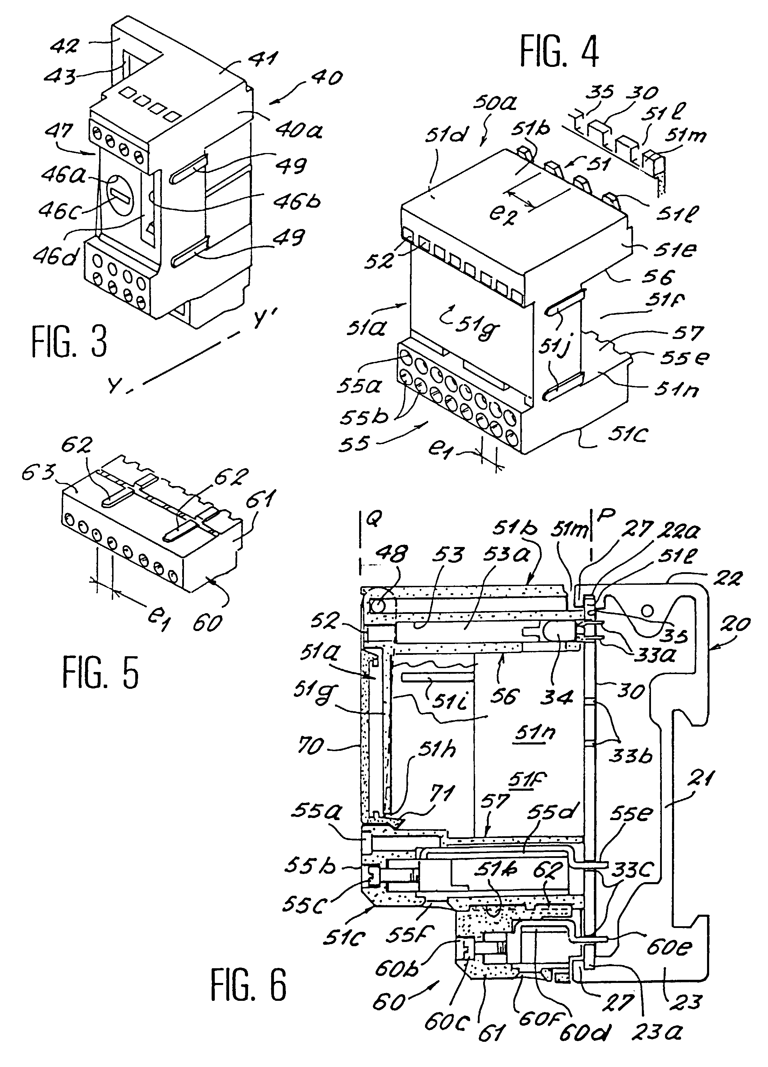

Le bloc d'alimentation 40 comprend un boîtier 41 muni d'une aile 42 dotée d'une ouverture 43 pour le passage du connecteur 31, de bornes hautes 44 et basses 45 pour le raccordement à une source d'énergie électrique et d'ouvertures frontales 46a,46b pour un fusible 46c et un sectionneur 46d (voir figure 3). L'aire centrale 47 de la façade du boîtier 41 est en retrait par rapport à ses zones affectées aux bornes 44,45 pour permettre de loger le couvercle pivotant 70. Un pivot 48 est prévu latéralement sur le boîtier 41 pour le montage pivotant du couvercle. Du côté du bloc d'interface voisin 50a, le bloc d'alimentation 40 présente dans une paroi latérale 40a deux nervures 49 à section en queue d'aronde orientées selon une direction Y-Y' orthogonale au plan P de la carte et coopérant avec des rainures complémentaires du bloc d'interface adjacent 50a pour rendre rigide leur assemblage.

Dans le présent mode de réalisation, les blocs d'interface modulaires 50a, 50b,.. sont fermés vers l'avant. Chacun présente un boîtier 51 muni d'une face avant 51a, d'une face supérieure 51b, d'une face inférieure 51c et de faces latérales 51d,51e et dégagent un espace interne médian 51f pour loger des groupes de composants, relais, circuits de traitement, .. non débrochables.

Les blocs 50 sont modulaires, c'est-à-dire ont une longueur I égale ou multiple entier d'un module déterminé, par exemple de 4 à 8 fois le pas des bornes, cette longueur étant adaptée au nombre de voies de l'équipement d'automatisation à gérer.

La face avant 51a comprend à sa partie haute une bandeau d'ouvertures 52 alignées régulièrement selon un pas e₁ et des canaux 53 qui logent des barrettes conductrices de lumière 53a orientées selon Y-Y' et qui débouchent d'une part sur les ouvertures 52, d'autre part en regard d'autant de diodes électroluminescentes 34 pour en faciliter la visualisation.

A sa partie basse, la face avant 51a présente un bandeau d'ouvertures dirigées selon Y-Y', à savoir une rangée d'ouvertures de test 55a et une rangée d'ouvertures d'accès 55b pour une première série de bornes 55 de pas e₁. Chaque borne 55 comprend une vis 55c accessible pour être manoeuvrée par l'ouverture 55b et une pièce électriquement conductrice 55d accessible pour un test électrique par l'ouverture 55a ; la pièce conductrice 55d est prolongée vers l'arrière par une patte de connexion 55e soudée dans un orifice 33c de la carte 30. On notera que les logements des barrettes conductrices de lumière 53a et des pièces électriquement conductrices 55d sont isolés de l'espace interne 51f du boîtier par des parois horizontales 56,57.

En arrière d'orifices 55f d'introduction des conducteurs à connecter dans la première rangée de bornes 55, on prévoit sous la face inférieure 51c du boîtier 51 une deuxième rangée de bornes 60 sous forme de bornier modulaire 61 de même longueur que celle du boîtier associé 51. Le bornier 61 est distinct du boîtier 51 et lui est rapporté de manière amovible, en retrait par rapport à la rangée de bornes 55, au moyen de nervures 62 prévues sur sa face supérieure 63 et coopérant avec des rainures 51k ménagées dans la face inférieure 51c du boîtier ; les nervures et rainures ont une forme en queue d'aronde et sont orientées orthogonalement au plan P de la carte. Chaque borne 60 comprend une ouverture d'accès 60b à une vis 60c, une pièce conductrice 60d éventuellement prolongée vers l'arrière par une patte de connexion 60e soudée dans un orifice 33c de la carte et une ouverture 60f d'introduction d'un conducteur. Le bornier 61 peut servir à assurer un potentiel commun ; en son absence, on peut disposer un bornier factice de mêmes dimensions.

Dans la partie médiane de la face avant 51a, c'est-à-dire entre sa partie haute à bandeau d'ouvertures et de visualisation 52 et sa partie basse à bandeau d'ouvertures 55a,55b d'accès à la première rangée de bornes 55, il existe un retrait central 51g ; la profondeur du retrait permet de loger dans celui-ci le couvercle pivotant 70 de manière que son plan avant Q soit situé au niveau des parties haute et basse de la face avant 51a. La zone inférieure du retrait central 51g comporte des évidements 51 h pour loger des doigts ou autres conformations d'encliquetage 71 du couvercle. Le boîtier 51 se présente en tant que capot à forme générale en U dont les branches logent respectivement des diodes et leurs conducteurs optiques et les pièces conductrices des bornes, tandis que l'âme du capot sert de plastron et forme un réceptacle pour le couvercle commun et protège un espace interne pour les éléments d'interface. On notera que les parois latérales 51d,51e des boîtiers 51 laissent dégagées des ouvertures 51n adaptées au gabarit de composants, par exemple de relais 35, de sorte que les parois externes de ces relais peuvent affleurer la face externe des parois 51d,51e.

Chaque boîtier modulaire d'interface 51 présente sur une face latérale 51d deux rainures en queue d'aronde 51i et sur la face latérale opposée 51e deux nervures complémentaires en queue d'aronde 51j, de manière que les différents boîtiers puissent être mutuellement assemblés de manière rigide par ces emboîtements selon la direction Y-Y' avant soudage de leurs pattes dans les orifices 33b,33c du circuit imprimé, pour composer le dispositif souhaité.

Le couvercle 70 est articulé par des pivots 48 aux extrémités du dispositif d'interfaçage, soit comme indiqué sur une face latérale du boîtier 41 d'alimentation et sur un flasque latéral 26, soit sur des faces latérales de deux boîtiers modulaires extrêmes 51a. Le couvercle peut être opaque ou transparent et porter une étiquette de repérage propre à l'utilisateur, tandis que la partie en retrait 51g de la face avant des boîtiers modulaires 51a porte une étiquette du schéma électrique préétabli.

Dans certaines versions du dispositif d'interfaçage, notamment les versions passives incluant seulement des éléments de visualisation hauts et borniers bas, il est souhaitable de renforcer la rigidité d'assemblage des boîtiers modulaires à l'embase. Dans ce but, les boîtiers 51a présentent à leur partie arrière des doigts ou crochets 51l disposés à intervalles réguliers e₂ multiples de e₁ ; on prévoit de même des encoches 35 au pas e₂ dans le bord supérieur de la carte 30. Les crochets 51e sont conçus pour se positionner dans les encoches 35 tout en laissant libre entre eux-mêmes et la face arrière du boîtier 51a un espace 51m dans lequel s'engage le rabattement profilé 27 de l'aile 22 de l'embase. La partie haute des blocs d'interface 50 est ainsi fermement maintenue dans l'embase 20 après introduction par coulissement de la carte 30, à laquelle sont soudés les blocs, dans les rainures 22a,23a de l'embase.

## Revendications

1. Dispositif d'interfaçage comprenant
- une carte à circuit imprimé (30) susceptible d'être reliée à une unité de traitement telle qu'un automate programmable,
- une embase allongée (20) dotée de rainures (22a,23a) disposées selon sa longueur pour recevoir la carte,
- des éléments d'interface actifs ou passifs reliés par des borniers à un équipement électrique susceptible d'être exploité ou commandé par l'unité de traitement, les éléments d'interface et les borniers étant soudés à la carte,
caractérisé par le fait que
- les éléments d'interface (34,53a ; 35 ; 55) sont logés dans des boîtiers modulaires distincts (51) dont les longueurs (I) sont égales ou multiples entier d'un module, chaque boîtier comprenant un bandeau d'ouvertures de visualisation (52) ou de manoeuvre pour des bornes, (55) réparties avec un pas déterminé (e₁)selon la longueur de l'embase,
- les boîtiers modulaires (51) présentent sur leurs faces latérales des rainures et languettes complémentaires (51i,51j) d'assemblage mutuel orientées perpendiculairement au plan (P) de la carte pour former un ensemble jointif composable et rigide.

2. Dispositif selon la revendication 1, caractérisé par le fait que les boîtiers modulaires (51) présentent une longueur multiple de quatre ou huit fois le pas des bornes (55).

3. Dispositif selon la revendication 1, caractérisé par le fait que le boîtier modulaire (51) comprend des canaux (53) logeant des barrettes conductrices de lumière (53a) et débouchant d'une part sur les ouvertures de visualisation et d'autre part sur une rangées de diodes électroluminescentes (34) prévues sur la carte.

4. Dispositif selon la revendication 1, caractérisé par le fait que le boîtier modulaire (51) intègre une première rangée de bornes (55) accessibles par le bandeau d'ouvertures de manoeuvre (52) et comprenant des pièces conductrices (55d) soudées à la carte (30).

5. Dispositif selon la revendication 4, caractérisé par le fait qu'à chaque boîtier modulaire (51) est associée une deuxième rangée de bornes (60) sous forme de bornier (61) fixé de manière amovible au boîtier par des rainures et languettes (62,51k) orthogonales au plan (P) de la carte et ce en retrait par rapport à la première rangée de bornes (55).

6. Dispositif selon la revendication 1, caractérisé par le fait que le boîtier modulaire (51) comporte des crochets (51l) de positionnement engagés dans des encoches (35) prévues à intervalles réguliers sur un bord longitudinal de la carte (30) et retenus par un rabattement longitudinal (27) de l'embase (20) adjacent à la rainure (22a) de l'embase qui loge le bord considéré.

7. Dispositif selon la revendication 1, caractérisé par le fait que le boîtier modulaire (51) se présente sous forme de capot à forme générale en U laissant dégagées des ouvertures latérales (51n) adaptées au gabarit de composants actifs (35) logés sous le capot.

8. Dispositif selon la revendication 4, caractérisé par le fait que le boîtier modulaire (51) présente, entre la rangée d'ouvertures de visualisation (52) et la première rangée de bornes (55), une partie centrale (51g) en léger retrait pour recevoir un couvercle longitudinal (70) commun à l'ensemble des boîtiers modulaires.

9. Dispositif selon la revendication 8, caractérisé par le fait que le couvercle commun (70) est monté pivotant sur des pivots (48) portés par les extrémités latérales de l'ensemble et présente des pattes (71) encliquetables dans des ouvertures (51h) ménagées à intervalles réguliers sur les boîtiers modulaires (51).

10. Dispositif selon la revendication 1, caractérisé par le fait qu'un bloc d'alimentation (40) fixé à la carte près d'une extrémité de l'embase (20) est muni sur une face latérale de rainures ou languettes (49) d'emboîtement dans des éléments complémentaires (51i,51j) d'un boîtier modulaire adjacent (51), ces rainures ou languettes étant orientées perpendiculairement au plan (P) de la carte (30).

## Patentansprüche

1. Schnittstellenvorrichtung mit
- einer Printplatte (30), die an eine Verarbeitungseinheit, wie zum Beispiel eine vorprogrammierbare Steuerung, angeschlossen werden kann,
- einem länglichen Sockel (20) mit nach ihrer Länge angeordneten Rillen (22a, 23a) zur Aufnahme der Printplatte,
- aktiven oder passiven Schnittstellenelementen, die mit Klemmleisten an eine elektrische Ausrüstung angeschlossen werden, die von der Verarbeitungseinheit betrieben oder gesteuert werden kann, wobei die Schnittstellenelemente und die Klemmleisten auf der Printplatte aufgeschweisst sind,
dadurch gekennzeichnet, dass
- die Schnittstellenelemente (34, 53a ; 35 ; 55) in verschiedenen modularen Kästen (51) angeordnet sind, deren Längen (1) einem Modul entsprechen oder ganze Vielfache davon sind, wobei jeder Kasten eine Leiste (52) mit Anzeige- oder Bedienungsöffnungen für die Klemmen (55) umfasst, die in einem je nach Länge des Sockels bestimmten Abstand (e1) verteilt sind,
- die modularen Kästen (51) an ihren Seitenflächen Rillen und ergänzende Laschen (51i, 51j) zum gegenseitigen Zusammenbau aufweisen, die lotgerecht zur Printplattenebene (P) ausgerichtet sind, um eine aneinanderstossende, zusammensetzbare und steife Baugruppe zu bilden.

2. Vorrichtung nach Anspruch 1, dadurch gekennzeichnet, dass die modularen Kästen (51) eine Länge aufweisen, die ein Vielfaches von vier oder acht Mal den Abstand der Klemmen (55) ist.

3. Vorrichtung nach Anspruch 1, dadurch gekennzeichnet, dass der modulare Kasten (51) zwei Kanäle (53) aufweist, in denen die Lichtleitklemmen (53a) angeordnet sind, und die einerseits in den Anzeigeöffnungen und andererseits an einer auf der Printplatte vorgesehenen Leuchtdiodenreihe (34) münden.

4. Vorrichtung nach Anspruch 1, dadurch gekennzeichnet, dass der modulare Kasten (51) eine erste Klemmenreihe (55) integriert, die über die Leiste mit den Bedienungsöffnungen (52) zugänglich ist und auf der Printplatte (30) aufgeschweisste Leiterteile (55d) umfasst.

5. Vorrichtung nach Anspruch 4, dadurch gekennzeichnet, dass jedem modularen Kasten (51) eine zweite Klemmenreihe (60) in Form einer Klemmleiste (61) zugeordnet ist, die mit rechtwinklig zur Ebene (P) der Printplatte angebrachten Rillen und Laschen (62, 51k) abnehmbar am Kasten befestigt und in bezug auf die erste Klemmenreihe (55) nach hinten versetzt ist.

6. Vorrichtung nach Anspruch 1, dadurch gekennzeichnet, dass der modulare Kasten (51) Positionierhaken (511) aufweist, die in Kerben (35) eingreifen, die in regelmässigen Abständen an einer Längskante der Printplatte (30) vorgesehen sind, und die von einem Längsumschlag (27) des Sockels (20) neben der Rille (22a) des die betrachtete Kante aufnehmenden Sockels festgehalten werden.

7. Vorrichtung nach Anspruch 1, dadurch gekennzeichnet, dass der modulare Kasten (51) eine im allgemeinen U-förmige Haube ist, die seitliche Öffnungen (51n) freilässt, die der Grösse der unter der Haube angeordneten aktiven Komponenten (35) angepasst sind.

8. Vorrichtung nach Anspruch 4, dadurch gekennzeichnet, dass der modulare Kasten (51) zwischen der Anzeigeöffnungsreihe (52) und der ersten Klemmenreihe (55) einen leicht nach hinten versetzten mittleren Bereich (5lg) zur Aufnahme eines länglichen Deckels (70) für alle modularen Kästen aufweist.

9. Vorrichtung nach Anspruch 8, dadurch gekennzeichnet, dass der gemeinsame Deckel (70) schwenkbar auf Drehzapfen (48) an den seitlichen Enden der Baugruppe montiert ist, und dass er Laschen (71) aufweist, die in die in regelmässigen Abständen an den modularen Kästen (51) vorgesehenen Öffnungen (51h) eingeklinkt werden.

10. Vorrichtung nach Anspruch 1, dadurch gekennzeichnet, dass ein in der Nähe eines Endes des Sockels (20) auf der Printplatte befestigtes Netzteil (40) auf einer Seitenfläche mit Rillen oder Laschen (49) zum Verschachteln mit ergänzenden Elementen (51i, 51j) eines angrenzenden modularen Kastens (51) ausgestattet ist, wobei diese Rillen oder Laschen lotgerecht zur Ebene (P) der Karte (30) ausgerichtet sind.

## Claims

1. Interface device comprising:
- a printed circuit board (30) adapted to be connected to a processor unit such as a programmable automatic controller,
- an elongate base (20) having lengthwise grooves (22a, 23a) to receive the board,
- active or passive interface devices connected by terminal blocks to an electrical equipment to be operated or controlled by the processor unit, the interface devices and the terminal blocks being soldered to the board,
characterised in that:
- the interface devices (34, 53a; 35; 55) are housed in separate modules (51) the lengths (l) of which are equal to or integer multiples of a modulus, each module comprising a strip of indicator openings (52) or terminal operating openings disposed lengthwise of the base at a particular pitch (e₁),
- the modules (51) have on their side faces complementary grooves and tongues (51i, 51j) for assembling them together oriented perpendicularly to the plane (P) of the board to form a rigid assembly.

2. Device according to claim 1 characterised in that the modules (51) have a length which is a multiple of 4 or 8 times the pitch of the terminals (55).

3. Device according to claim 1 characterised in that the module (51) comprises passages (53) accommodating light conducting rods (53a) and having respective ends facing the indicator openings and a row of light-emitting diodes (34) on the board.

4. Device according to claim L characterised in that the module (51) integrates a first row of terminals (55) accessible via the strip of operating openings (52) and comprising conductive members (55d) soldered to the board (30).

5. Device according to claim 4 characterised in that each module (51) is associated with a second row of terminals (60) in the form of a terminal block (61) removably fixed to the module by grooves and tongues (62, 51k) orthogonal through the plane (P) of the board and set back relative to the first row of terminals (55).

6. Device according to claim 1 characterised in that the module (51) includes locating hooks (51l) engaged in notches (35) at regular intervals along one longitudinal edge of the board (30) and retained by a longitudinal upstand (27) of the base (20) adjacent the groove (22a) in the base accommodating the edge concerned.

7. Device according to claim 1 characterised in that the module (51) is generally U-shaped with openings (51n) at the sides matched to the external dimensions of active components (35) housed inside the module.

8. Device according to claim 4 characterised in that the module (51) has, between the row of indicator openings (52) and the first row of terminals (55), a central part (51g) that is slightly set back to receive a longitudinal cover (70) common to all the modules.

9. Device according to claim 8 characterised in that the common cover (70) is pivotably mounted on pivots (48) carried by the lateral ends of the assembly and has lugs (71) that clip into openings (51h) provided at regular intervals on the modules (51).

10. Device according to claim 1 characterised in that a power supply unit (40) fixed to the board near one end of the base (20) has grooves or tongues (49) on one side face that nest in complementary members (51i, 51j) of an adjacent module (51), these grooves or tongues being oriented perpendicularly to the plane (P) of the board (30).
